# EUROPEAN PATENT APPLICATION

(11) **EP 2 672 521 A1**
(43) Date of publication of application: **11.12.2013**
(21) Application number: 11857798.0
(22) Date of filing: 01.09.2011
(51) Int. Cl.: H01L 31/04

(54) **THIN FILM PHOTOVOLTAIC CELL AND METHOD OF PRODUCING SAME**

(30) Priority: 31.01.2011 JP 2011018206
(71) Applicant: Fuji Electric Co. Ltd., Kanagawa 210-9530 (JP)
(72) Inventor: TAKEUCHI, Masaki, Kawasaki-shi Kanagawa 210-9530 (JP); NAKAHARA, Hiroaki, Kawasaki-shi Kanagawa 210-9530 (JP); WADA, Takehito, Kawasaki-shi Kanagawa 210-9530 (JP); SAWAYANAGI, Satoshi, Kawasaki-shi Kanagawa 210-9530 (JP)
(74) Representative: Appelt, Christian W.
(86) International application number: PCT/JP2011/069874
(87) International publication number: WO 2012/105079

(57) **Abstract**

The object of the present invention is to provide a thin-film photovoltaic cell in which the effective surface area of a transparent electrode layer can be increased to increase the output of the thin-film photovoltaic cell, and the defect ratio in the manufacture of the thin-film photovoltaic cell can be reduced by ensuring insulation property in second through holes, and also to provide a method for manufacturing such a thin-film photovoltaic cell. In a thin-film photovoltaic cell 1 in accordance with the present invention, a rear-face electrode layer 3a, a photoelectric conversion layer 4, and a transparent electrode layer 5 are stacked in this order on one face 2a of an insulating substrate 2. A first back-face electrode layer 3b and a second back-face electrode layer 6 are stacked in this order on the other face 2b of the insulating substrate 2. Further, the transparent electrode layer 5 and the second back-face electrode layer 6 are electrically connected to each other via first through holes 7 passing through the insulating substrate 2, and the rear-face electrode layer 3a and the first back-face electrode layer 3b are electrically connected to each other via second through holes 8 passing through the insulating substrate 2. In accordance with the present invention, the transparent electrode layer 5 around the second through holes 8 is separated by grooves 11, and the transparent electrode layer 5 and the second back-face electrode layer 6 are electrically insulated from each other.

## Description

### TECHNICAL FIELD

The present invention relates to a thin-film photovoltaic cell in which a metal electrode layer, a photoelectric conversion layer, and a transparent electrode layer are stacked on a film substrate.

### BACKGROUND ART

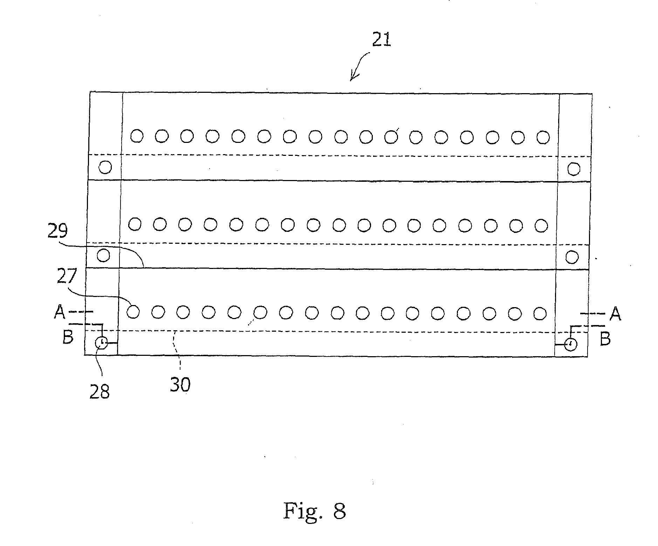

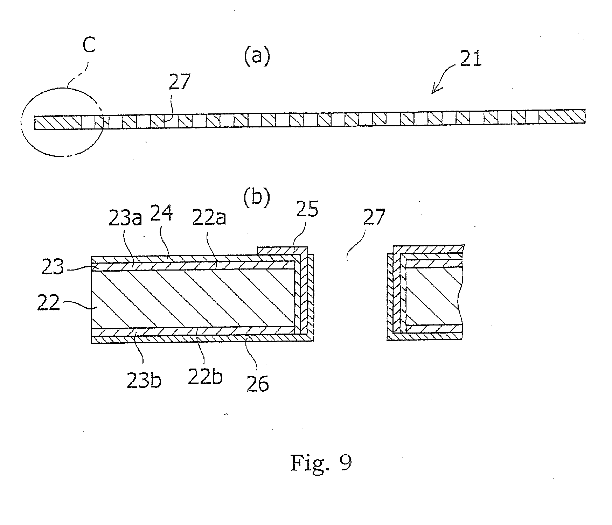

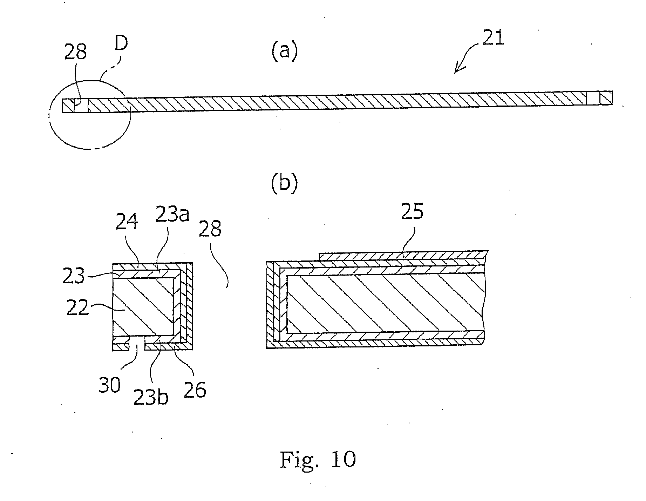

FIG. 8 is a plan view of the conventional thin-film photovoltaic cell. FIG. 9 is a cross-sectional view taken along the A-A line in FIG. 8. FIG. 10 is a cross-sectional view taken along the B-B line in FIG. 8.
As shown in FIG. 9 and FIG. 10, the conventional thin-film photovoltaic cell 21 is provided with an insulating substrate 22. Metal electrode layers 23 are formed on both faces 22a, 22b of the insulating substrate 22. In this configuration, the metal electrode layer 23 on one face 22a of the insulating substrate 22 functions as a rear-face electrode layer 23a, and the metal electrode layer 23 on the other face 22b of the insulating substrate 22 functions as a first back-face electrode layer 23b.

As shown in FIG. 9 and FIG. 10, a photoelectric conversion layer 24 and a transparent electrode layer 25 are stacked in the order of description on the rear-face electrode layer 23a. A second back-face electrode layer 26 is stacked on the first back-face electrode layer 23b.
Further, as shown in FIG. 8 and FIG. 9, first through holes 27 that pass through the insulating substrate 22 are provided in the insulating substrate 22, and the transparent electrode layer 25 and the second back-face electrode layer 26 are electrically connected through the first through holes 27. Further, as shown in FIG. 8 and FIG. 10, second through holes 28 that pass through the insulating substrate 22 are provided in the insulating substrate 22, and the rear-face electrode layer 23a and the first back-face electrode layer 23b are electrically connected through the second through holes 28.

The layer stacked on the one face 22a of the insulating substrate 22 shown in FIG. 9 is divided by first patterning lines 29 as shown in FIG. 8, and the layer stacked on the other face 22b of the insulating substrate 22 shown in FIG. 10 is divided by second patterning lines 30 as shown in FIG. 8 and FIG. 10. As a result, the layers stacked on the insulating substrate 22 are divided into a plurality of unit cells.
In this configuration, the first patterning lines 29 and the second patterning lines 30 are disposed alternately at the insulating substrate 22. The separation positions of the electrode layers on both faces 22a, 22b of the insulating substrate 22 are shifted with respect to each other, and by connecting the electrode layers on both faces 22a, 22b of the insulating substrate 22 by the second through holes 28, a structure is obtained in which the adjacent unit cells are connected in series.

Patent Document 1 discloses another example of the conventional thin-film photovoltaic cell. In the thin-film photovoltaic cell described in Patent Document 1, a first electrode layer, a photoelectric conversion layer, and a second electrode layer are stacked on one face of a film substrate constituted by an electrically insulating resin, and a third electrode layer and a fourth electrode layer are stacked on the opposite side (rear face) of the film substrate.

Patent Document 2 discloses yet another example of the conventional thin-film photovoltaic cell. In the thin-film photovoltaic cell described in Patent Document 2, a connection hole is closed by a printed electrode constituted by a conductive material (see, in particular, paragraph [0035] and FIG. 27).

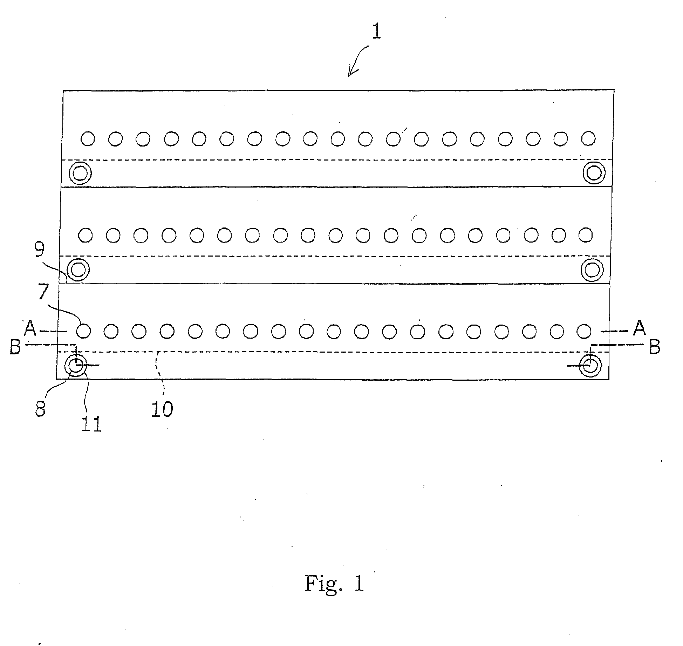

In the configuration disclosed in Patent Document 3, a transparent electrode layer is formed over the entire width of a photoelectric conversion layer. Region separation lines that electrically separate regions close to connection holes (second through holes) and regions including current collecting holes (first through holes) are formed in the transparent electrode layer (see, in particular, paragraph [0046] and FIG. 1).

Further, Non-Patent Document 1 describes laser patterning performed when a thin-film photovoltaic cell is manufactured. In Non-Patent Document 1, an excimer laser with a wavelength of 248 nm and a pulse width of 40 ns is used (see page 39).

Patent Document 1: Japanese Patent Application Publication No. 2001-298203
Patent Document 2: Japanese Patent Application Publication No. H6-342924
Patent Document 3: Japanese Patent Application Publication No. 2003-60219

Non-Patent Document 1: SANYO TECHNICAL REVIEW, vol. 36, No. 2, DEC. 2004, p34-p42

However, the following problems are associated with the configurations shown in the above-described FIG. 8 to FIG. 10.
In the conventional configuration, mask treatment is performed by applying a metal mask in the vicinity of the second through holes 28 when the transparent electrode layer 25 is formed so as to prevent the transparent electrode layer 25 from coming into contract with the second back-surface electrode layer 26 in the second through holes 28. When a metal mask is used, the production conditions during mask treatment and the necessity of ensuring a margin for wrapping around the film during film formation should be taken into account, and the surface area of the metal mask is much larger than the second through holes 28. Therefore, as shown in FIG. 10(b), the portion where the transparent electrode layer 25 is not formed becomes large in the vicinity of the second through holes 28, and the effective area of the transparent electrode layer 25 is restricted.
Therefore, a structure is required that ensures the effective surface area of the transparent electrode layer 25.

Further, when the vicinity of the second through holes 28 is masked, the transparent electrode layer 25 located on the insulating substrate 22 can be damaged by contact between the mask and the transparent electrode layer 25 located on the insulating substrate 22. In particular, in the process described in Patent Document 3, a fine wire mask is used and therefore it is highly probable that the transparent electrode layer 25 will be damaged by contact between the transparent electrode layer 25 and the mask.
The problems occurring when the layer located on the insulating substrate 22 is thus damaged are that the leakage current increases and the defect ratio in the production of the thin-film photovoltaic cells 21 increases.

Further, with the technique disclosed in Patent Document 2, the connection holes are closed by a conductive material. The resultant problem is that the insulation property in the connection holes is not sufficient and the leakage current increases.

In the configuration described in Patent Document 3, the connection holes are closed with an insulating resin such as a polyimide resin or a polyamide resin, but the insulating resin is coated before the semiconductor layer is formed. The resultant problem is that moisture adsorbed by the insulating resin from the atmosphere is released when the semiconductor layer is formed and properties of the thin-film solar cell are degraded. Further, since a significant time is required for curing the insulating resin, the production cost rises. In addition, since the substrate thickness is locally increased by the resin thickness, problems easily occur when the substrate is transported.

Further, Non-Patent Document 1 describes the wavelength and pulse width of the laser beam used for laser patterning, but no conditions relating to energy density are described. The resultant problem is that even when laser patterning is performed under the conditions described in Non-Patent Document 1, the modification of the surrounding power-generating layer (photoelectric conversion layer and the like) that is subjected to laser processing cannot be prevented.

### DISCLOSURE OF THE INVENTION

The present invention has been created with the foregoing in view and it is an object of the present invention to provide a thin-film photovoltaic cell in which the effective surface area of a transparent electrode layer can be increased to increase the output of the thin-film photovoltaic cell, and the defect ratio in the manufacture of the thin-film photovoltaic cell can be reduced by ensuring insulation property in second through holes, and also to provide a method for manufacturing such a thin-film photovoltaic cell.

In order to resolve the aforementioned problems inherent to related art, the present invention provides a thin-film photovoltaic cell in which a rear-face electrode layer, a photoelectric conversion layer, and a transparent electrode layer are stacked in the order of description on one face of an insulating substrate, a first back-face electrode layer and a second back-face electrode layer are stacked in this order on the other face of the insulating substrate, the insulating substrate is divided into a plurality of unit cells by forming patterning lines alternately in the layers stacked on both faces of the insulating substrate, the transparent electrode layer and the second back-face electrode layer are electrically connected to each other via a first through hole passing through the insulating substrate, the rear-face electrode layer and the first back-face electrode layer are electrically connected to each other via a second through hole passing through the insulating substrate, and the adjacent unit cells are connected in series, wherein the transparent electrode layer around the second through holes is separated by grooves, and the transparent electrode layer and the second back-face electrode layer are electrically insulated from each other.

Further, in the thin-film photovoltaic cell in accordance with the present invention, the groove of the transparent electrode layer is formed by irradiation with a pulsed laser.

Further, in the thin-film photovoltaic cell in accordance with the present invention, the groove of the transparent electrode layer are formed by irradiation with a laser beam with a wavelength in a UV radiation range.

Further, in the thin-film photovoltaic cell in accordance with the present invention, the insulating substrate is formed from a heat-resistant film of a polyimide, a polyamidoimide, or polyethylene naphthalate.

In order to resolve the aforementioned problems inherent to related art, the present invention also provides a thin-film photovoltaic cell in which a rear-face electrode layer, a photoelectric conversion layer, and a transparent electrode layer are stacked in this order on one face of an insulating substrate, a first back-face electrode layer and a second back-face electrode layer are stacked order on the other face of the insulating substrate, the insulating substrate is divided into a plurality of unit cells by forming patterning lines alternately in the layers stacked on both faces of the insulating substrate, the transparent electrode layer and the second back-face electrode layer are electrically connected to each other via a first through hole passing through the insulating substrate, the rear-face electrode layer and the first back-face electrode layer are electrically connected to each other via a second through hole passing through the insulating substrate, and the adjacent unit cells are connected in series, wherein the transparent electrode layer around the second through hole is separated by a groove, the transparent electrode layer and the second back-face electrode layer are electrically insulated from each other, and the groove is formed using a YAG-THG laser (wavelength 355 nm) with a beam energy density adjusted to 0.2 to 0.3 J/cm².

Further, in the thin-film photovoltaic cell in accordance with the present invention, the groove of the transparent electrode layer is formed using a laser with a round or rectangular beam shape and a Gaussian or top-hat beam profile.

Further, in the thin-film photovoltaic cell in accordance with the present invention, the groove of the transparent electrode layer is formed using a laser with a pulse width equal to or less than 20 ps.

Further, in the thin-film photovoltaic cell in accordance with the present invention, the insulating substrate is formed from a heat-resistant film of a polyimide, a polyamidoimide, or polyethylene naphthalate.

In order to resolve the aforementioned problems inherent to related art, the present invention also provides a method for manufacturing a thin-film photovoltaic cell, including: a step of forming a second through hole in an insulating substrate; a step of forming a rear-face electrode layer on one face of the insulating substrate and forming a first back-face electrode layer on the other face of the insulating substrate; a step of forming a first through hole in the insulating substrate after the rear-face electrode layer and the first back-face electrode layer have been formed; a step of stacking a photoelectric conversion layer and a transparent electrode layer in this order from the one face side of the insulating substrate, and stacking a second back-face electrode layer from the other face side of the insulating substrate; a step of forming patterning lines alternately in the layers stacked on both faces of the insulating substrate and dividing the insulating substrate into a plurality of unit cells; and a step of forming a groove in the transparent electrode layer around the second through hole and electrically insulating the transparent electrode layer and the second back-face electrode layer from each other.

Further, in the method for manufacturing a thin-film photovoltaic cell in accordance with the present invention, the step of forming the groove in the transparent electrode layer around the second through hole is performed by irradiation with a pulsed laser.

Further, in the method for manufacturing a thin-film photovoltaic cell in accordance with the present invention, the step of forming the groove in the transparent electrode layer around the second through hole is performed by irradiation with a laser beam with a wavelength in a UV radiation range.

Further, in the method for manufacturing a thin-film photovoltaic cell in accordance with the present invention, the step of forming the groove in the transparent electrode layer around the second through hole is performed by irradiation with a YAG-THG laser beam (wavelength 355 nm) with a beam energy density adjusted to 0.2 to 0.3 J/cm².

Further, in the method for manufacturing a thin-film photovoltaic cell in accordance with the present invention, the step of forming the groove in the transparent electrode layer around the second through hole is performed by irradiation with a laser with a round or rectangular beam shape and a Gaussian or top-hat beam profile.

Further, in the method for manufacturing a thin-film photovoltaic cell in accordance with the present invention, the step of forming the grooves in the transparent electrode layer around the second through holes is performed by irradiation with a laser with a pulse width equal to or less than 20 ps.

In the thin-film photovoltaic cell in accordance with the present invention, a rear-face electrode layer, a photoelectric conversion layer, and a transparent electrode layer are stacked in this order on one face of an insulating substrate, a first back-face electrode layer and a second back-face electrode layer are stacked in the order of description on the other face of the insulating substrate, the insulating substrate is divided into a plurality of unit cells by forming patterning lines alternately in the layers stacked on both faces of the insulating substrate, the transparent electrode layer and the second back-face electrode layer are electrically connected to each other via first through holes passing through the insulating substrate, the rear-face electrode layer and the first back-face electrode layer are electrically connected to each other via second through holes passing through the insulating substrate, and the adjacent unit cells are connected in series, wherein the transparent electrode layer around the second through holes is separated by grooves, and the transparent electrode layer and the second back-face electrode layer are electrically insulated from each other. In the related art, mask treatment is performed or an insulating resin is disposed around the second through holes, but in accordance with the present invention, electric insulation between the transparent electrode layer and the second back-face electrode layer can be ensured without performing such a treatment. Furthermore, because of the configuration in which the transparent electrode layer is removed without performing the mask treatment around the second through holes, the region where the transparent electrode layer is not formed can be reduced by comparison with that obtained with the mask treatment, and the effective surface area of the transparent electrode layer can be enlarged. As a result, the output of the thin-film photovoltaic cell can be increased.

Further, in the thin-film photovoltaic cell in accordance with the present invention, the grooves of the transparent electrode layer are formed by irradiation with a pulsed laser. Therefore, short circuiting of a power-generating layer such as the photoelectric conversion layer caused by crystallization can be inhibited.

Further, in the thin-film photovoltaic cell in accordance with the present invention, the grooves of the transparent electrode layer are formed by irradiation with a laser beam with a wavelength in a UV radiation range. Therefore, light absorption in the transparent electrode layer can be increased and thermal damage of the power-generating layer can be reduced.

Further, in the thin-film photovoltaic cell in accordance with the present invention, a rear-face electrode layer, a photoelectric conversion layer, and a transparent electrode layer are stacked in the order of description on one face of an insulating substrate, a first back-face electrode layer and a second back-face electrode layer are stacked in the order of description on the other face of the insulating substrate, the insulating substrate is divided into a plurality of unit cells by forming patterning lines alternately in the layers stacked on both faces of the insulating substrate, the transparent electrode layer and the second back-face electrode layer are electrically connected to each other via first through holes passing through the insulating substrate, the rear-face electrode layer and the first back-face electrode layer are electrically connected to each other via second through holes passing through the insulating substrate, and the adjacent unit cells are connected in series, wherein the transparent electrode layer around the second through holes is separated by grooves, the transparent electrode layer and the second back-face electrode layer are electrically insulated from each other, and the grooves are formed using a YAG-THG laser (wavelength 355 nm) with a beam energy density adjusted to 0.2 to 0.3 J/cm². Therefore, modification (that is, crystallization or the like) of the surrounding power-generating layer such as the photoelectric conversion layer by laser processing can be inhibited.
Further, since a laser in a UV range (wavelength equal to or less than 400 nm) is used for processing, light absorption in the transparent electrode layer can be increased and thermal damage of the power-generating layer can be reduced.

Further, in the thin-film photovoltaic cell in accordance with the present invention, the grooves of the transparent electrode layer are formed using a laser with a pulse width equal to or less than 20 ps. Therefore, the time width of the laser pulse is shortened and thermal influence can be reduced.

The method for manufacturing a thin-film photovoltaic cell in accordance with the present invention includes: a step of forming second through holes in an insulating substrate; a step of forming a rear-face electrode layer on one face of the insulating substrate and forming a first back-face electrode layer on the other face of the insulating substrate; a step of forming first through holes in the insulating substrate after the rear-face electrode layer and the first back-face electrode layer have been formed; a step of stacking a photoelectric conversion layer and a transparent electrode layer in the order of description from the one face side of the insulating substrate, and stacking a second back-face electrode layer from the other face side of the insulating substrate; a step of forming patterning lines alternately in the layers stacked on both faces of the insulating substrate and dividing the insulating substrate into a plurality of unit cells; and a step of forming grooves in the transparent electrode layer around the second through holes and electrically insulating the transparent electrode layer and the second back-face electrode layer from each other. In the related art, it is necessary to perform mask treatment or dispose an insulating resin around the second through holes, but in accordance with the present invention, it is not necessary to perform a mask treatment or the like in the vicinity of the second through holes, as in the related art, and the production yield of the thin-film photovoltaic cell 1 can be increased. In addition, because no mask treatment is necessary to perform in the vicinity of the second through holes, the layer located on the insulating substrate 2 that is in contact with the mask and the insulating substrate 2 is prevented from damage. As a result, the leak current is prevented from increasing in the thin-film photovoltaic cell 1 and the defect ratio in the production of the thin-film photovoltaic cell 1 can be reduced.

### BRIEF DESCRIPTION OF THE DRAWINGS

FIG. 1 is a plan view of the thin-film photovoltaic cell according to the first embodiment of the present invention.
FIG. 2 is a cross-sectional view taken along the A-A line in FIG. 1.
FIG. 3 is an enlarged view of the area C in FIG. 2.
FIG. 4 is a cross-sectional view taken along the B-B line in FIG. 1.
FIG. 5 is an enlarged view of the area D in FIG. 4; FIG. 5(a) is a cross-sectional view before the transparent electrode layer is removed; FIG. 5(b) is a cross-sectional view after the transparent electrode layer has been removed.
FIG. 6 is a flowchart illustrating how the thin-film photovoltaic cell of the first embodiment of the present invention is manufactured.
FIG. 7 illustrates the relationship between the energy density and crystallization ratio in the case of fabricating the transparent electrode layer by laser beam irradiation.
FIG. 8 is a plan view illustrating the conventional thin-film photovoltaic cell.
FIG. 9(a) is a cross-sectional view taken along the A-A line in FIG. 8; FIG. 9(b) is an enlarged view of the area C in FIG. 9(a).
FIG. 10(a) is a cross-sectional view taken along the B-B line in FIG. 8; FIG. 10(b) is an enlarged view of the area D in FIG. 10(a).

### BEST MODE FOR CARRYING OUT THE INVENTION

The thin-film photovoltaic cells of embodiments of the present invention will be described below with reference to the appended drawings. FIG. 1 is a plan view of the thin-film photovoltaic cell according to the first embodiment.

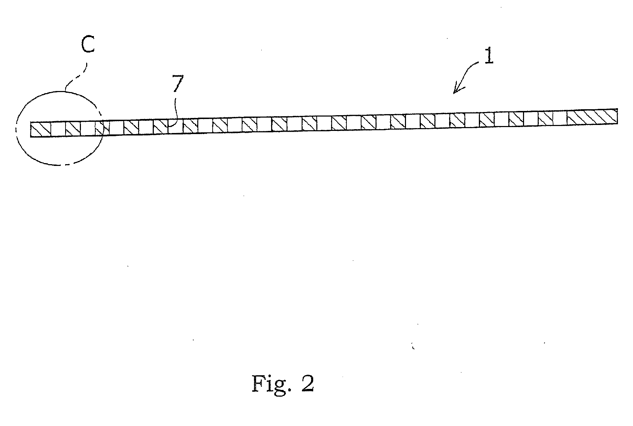

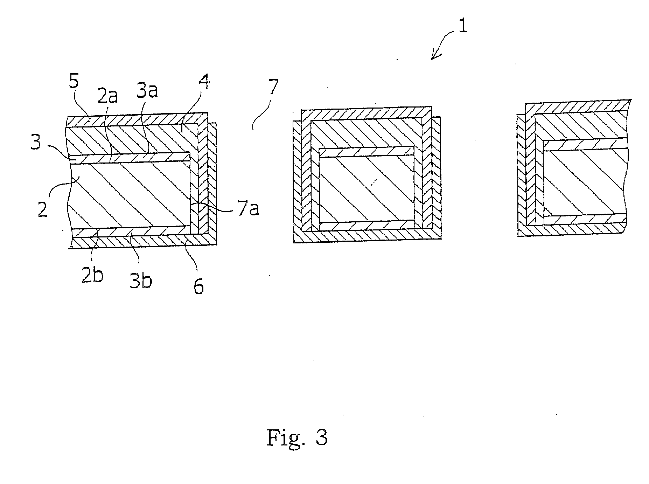

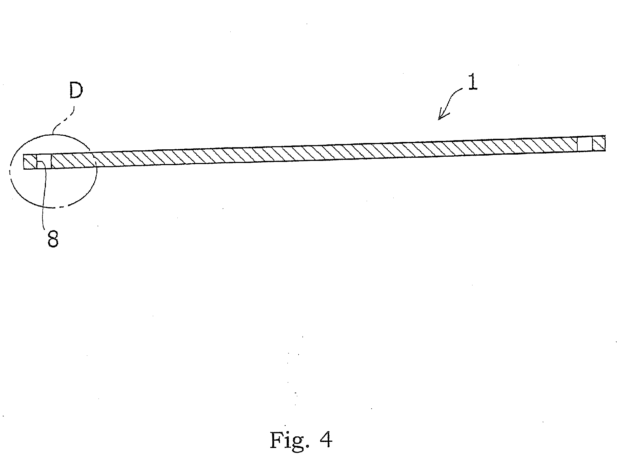

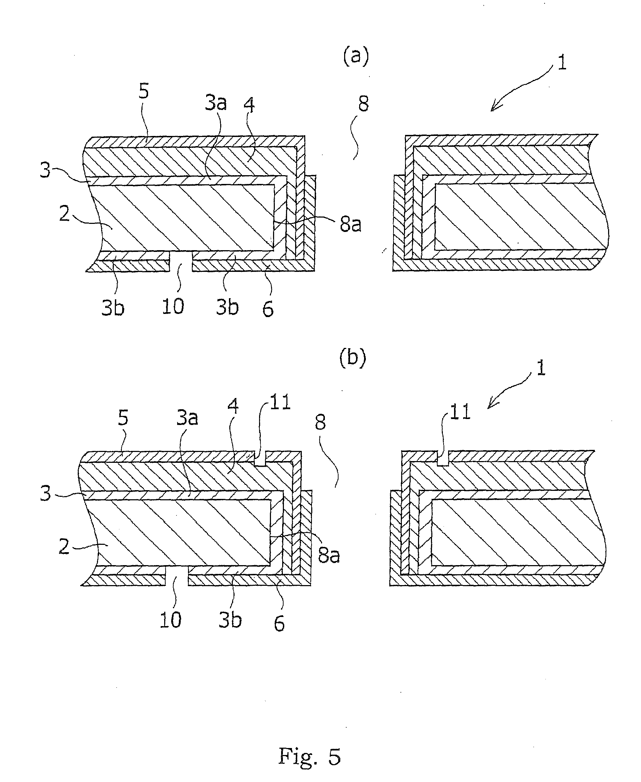

FIG. 2 is a cross-sectional view taken along the A-A line in FIG. 1. FIG. 3 is an enlarged view of the area C in FIG. 2. FIG. 4 is a cross-sectional view taken along the B-B line in FIG. 1. FIG. 5 is an enlarged view of the area C in FIG. 4.

### First Embodiment

As shown in FIG. 1 to FIG. 5, a thin-film photovoltaic cell 1 according to the present embodiment is provided with an insulating substrate 2 (see FIG. 3 and FIG. 5). The insulating substrate 2 is formed from a film material, for example, from a material such as a polyimide, a polyamidoimide, polyethylene naphthalate, or an aramide.

As shown in FIG. 3, a metal electrode layer 3 constituted by a metal such as Ag/ZnO is formed on both faces 2a, 2b of the insulating substrate 2. In this configuration, the metal electrode layer 3 on one face 2a of the insulating substrate 2 functions as a rear-face electrode layer 3a, and the metal electrode layer 3 on the other face 2b of the insulating substrate 2 functions as a first back-face electrode layer 3b.

Further, as shown in FIG. 3 and FIG. 5, a photoelectric conversion layer 4 and a transparent electrode layer 5 are stacked in the order of description on the rear-face electrode layer 3a located on the one face 2a of the insulating substrate 2. An amorphous semiconductor or an amorphous semiconductor including microcrystals, a dye-sensitized photovoltaic cell, an organic photovoltaic cell, or a CIGS-type organic photovoltaic cell can be used as the photoelectric conversion layer 4. Meanwhile, a second back-face electrode layer 6 is stacked on the first back-face electrode layer 3b located on the other face 2b of the insulating substrate 2.

As shown in FIG. 1, a plurality of first through holes 7 that passes through the insulating substrate 2 is provided in the insulating substrate 2. The first through holes 7 are disposed with a constant spacing. Further, as shown in FIG. 3, the transparent electrode layer 5 and the second back-face electrode layer 6 are connected in a manner such that the two electrode layers overlap on a side wall portion 7a of the first through hole 7.

As shown in FIG. 1, a plurality of second through holes 8 that passes through the insulating substrate 2 is provided in the insulating substrate 2. In the present embodiment, the second through holes 8 are disposed at both ends in the width direction of the insulating substrate 2 of the thin-film photovoltaic cell 1. As shown in FIG. 5, the rear-face electrode layer 3a and the first back-face electrode layer 3b are electrically connected by the side wall portions 8a of the second through holes 8.
Thus, the first and second through holes 7, 8 are used for connection in the following order; first and second back-face electrode layers 3b, 6 → first through holes 7 → transparent electrode layer 5 → photoelectric conversion layer 4 → rear-face electrode layer 3a → second through holes 8 → first back-face electrode layer 3b.

As shown in FIG. 1, the layers (rear-face electrode layer 3a, photoelectric conversion layer 4, transparent electrode layer 5) stacked on the one face 2a of the insulating substrate 2 are divided into a plurality of sections by first patterning lines 9 obtained by laser fabrication.
Further, as shown in FIG. 1 and FIG. 5, the layers (first back-face electrode layer 3b and second back-face electrode layer 6) stacked on the other face 2b of the insulating substrate 2 are similarly divided into a plurality of sections by second patterning lines 10 obtained by laser fabrication. In this configuration, the first patterning lines 9 and the second patterning lines 10 are disposed alternately at the insulating substrate 2.
Those first and second patterning lines 9, 10 perform the division into unit cells (unit photovoltaic cells) constituted by the layers located on the one face 2a and the layers located on the other face 2b of the insulating substrate 2. The thin-film photovoltaic cell 1 has a structure in which the separation positions of the electrode layers on both faces 2a, 2b of the insulating substrate 2 are shifted with respect to each other and the adjacent unit cells are connected in series by connecting the electrode layers on both faces 2a, 2b of the insulating substrate 2 by the second through holes 28.

The specific feature of the present embodiment is that an operation of removing the transparent electrode layer 5 around the second through holes 8 is performed, as shown in FIG. 1 and FIG. 5(b). More specifically, as shown in FIG. 1 and FIG. 5(b), a separation groove 11 is provided around the second through hole 8. The separation groove 11 is formed radially outside of the second through hole 8. Thus, as shown in FIG. 5(b), the separation groove 11 is positioned radially outside of the side wall portion 8a of the second through hole 8.

As shown in FIG. 1, the separation groove 11 is formed concentrically with the second through hole 8 and annularly in the plane view thereof. Further, as shown in FIG. 5(b), the depth of the separation groove 11 is such that the separation groove reaches the photoelectric conversion layer 4 and electrically insulates the transparent electrode layer 5 and the second transparent electrode layer 6 from each other.

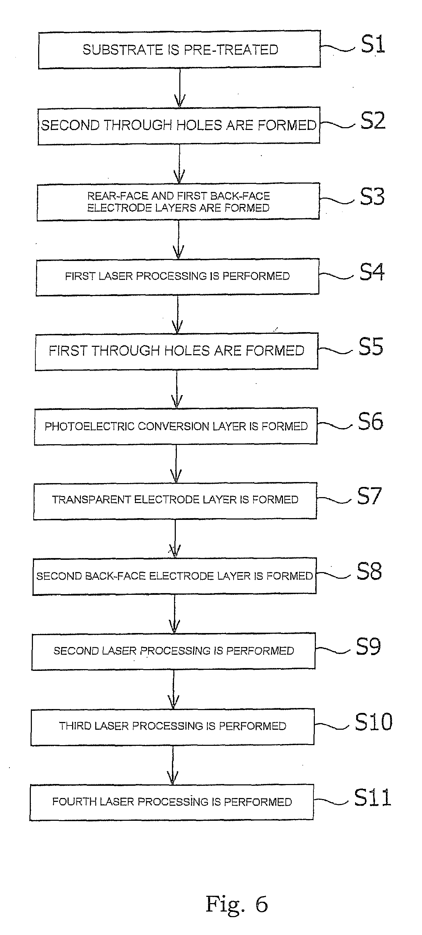

A method for manufacturing the thin-film photovoltaic cell according to the embodiment of the present invention will be described below with reference to the appended drawings. FIG. 6 is a flowchart illustrating how the thin-film photovoltaic cell 1 of the first embodiment of the present invention is manufactured.

A film material such as described hereinabove is used as the insulating substrate 2 in the thin-film photovoltaic cell 1 according to the present embodiment. A printing technique of a roll-to-roll or ink jet system is used as a method for manufacturing the thin-film photovoltaic cell 1. For example, in the roll-to-roll system, a substrate from a film material is conveyed by a plurality of rollers (conveying means) and a thin film is continuously formed on the substrate in a continuously arranged film formation chamber.

When the thin-film photovoltaic cell 1 is manufactured, first, the insulating substrate 2 is pre-treated in step S1 as shown in FIG. 6. More specifically, the pretreatment is performed to maximize deformations of the substrate by applying a tensile force to the insulating substrate 2 under heating.

Then, in step S2, the second through holes 8 are formed in the insulating substrate 2. The second through holes 8 are formed by punching (piercing method). A circle with a diameter of 1 mm is selected as a shape of the second through hole 8. The diameter of the circle of the second through holes 8 can be set within a range of 0.05 to 1 mm, and the number of punched second through holes 8 can be adjusted according to the design.

Then, in step S3, the rear-face electrode layer 3a and the first back-face electrode layer 3b are formed on both faces 2a, 2b of the insulating substrate 2 by sputtering. In this case, the rear-face electrode layer 3a and the first back-face electrode layer 3b are electrically connected via the second through holes 8.
Then, in step S4, primary patterning lines (not shown in the figures) are formed by removing the layers formed on both faces 2a, 2b of the insulating substrate 2 by laser processing. In this case, the lines formed on both faces 2a, 2b of the insulating substrate 2 are displaced with respect to each other.
Then, in step S5, first through holes 7 are formed in the insulating substrate 2. The first through holes 7 are formed by punching.

Then, in step S6, the photoelectric conversion layer 4 is formed on the rear-face electrode layer 3a of the insulating substrate 2, and then, in step S7, the transparent electrode layer 5 is further formed on the photoelectric conversion layer 4.
Then, in step S8, the second back-face electrode layer 6 is formed on the first back-face electrode layer 3b of the insulating substrate 2.

Then, in step S9, the first patterning lines 9 are formed by removing again the photoelectric conversion layer 4 and the transparent electrode layer 5 located on the primary patterning lines, which have been formed in step S4, by laser processing.
Then, in step S10, the second patterning lines 10 are formed by removing again the second back-face electrode layer 6 located on the primary patterning lines, which have been formed in step S4, by laser processing. The layers located on the insulating substrate 2 are separated into a plurality of unit cells by these first and second patterning lines 9, 10.

Then, in step S11, separation grooves (third patterning lines) 11 are formed around the second through holes 8 by performing laser processing of the transparent electrode layer 5 around the second through holes 8. The separation grooves 11 are formed concentrically with the second through holes 8 and radially outside of the second through holes 8 (see FIG. 1). Further, the depth of the separation grooves 11 is such that the separation grooves reach the photoelectric conversion layer 4 (see FIG. 5(b)).
As a result, the transparent electrode layer 5 outside the separation grooves 11 and the rear-face electrode layer 6 or the first back-face electrode layer 3b are separated by the separation grooves 11. As a result, the transparent electrode layer 5 and the rear-face electrode layer 6 are electrically insulated from each other.

A pulsed laser can be used for forming the separation grooves 11. By using a pulsed laser, it is possible to suppress the short circuiting caused by crystallization of the power-generating layer. Further, the wavelength of the pulsed laser may be set in the UV radiation range. By setting the wavelength in the UV radiation range, it is possible to increase the effect of ablation by which the molecules are disconnected and removed, while reducing thermal influence.
Where the time width of the pulsed laser pulses is short, thermal influence can be suppressed. The time width of the pulsed laser pulses may be set to a value equal to or less than 100 ps, preferably equal to or less than 20 ps. In this way, the serial connection is accomplished in the thin-film photovoltaic cell 1.

In the thin-film photovoltaic cell 1 according to the first embodiment of the present invention, the rear-face electrode layer 3a, the photoelectric conversion layer 4, and the transparent electrode layer 5 are stacked in the order of description on the one face 2a of an insulating substrate 2, the first back-face electrode layer 3b and the second back-face electrode layer 6 are stacked in the order of description on the other face 2b of the insulating substrate 2, the insulating substrate 2 is divided into a plurality of unit cells by forming first and second patterning lines 9, 10 alternately in the layers stacked on both faces 2a, 2b of the insulating substrate 2, the transparent electrode layer 5 and the second back-face electrode layer 6 are electrically connected to each other via the first through holes 7 passing through the insulating substrate 2, the rear-face electrode layer 3a and the first back-face electrode layer 3b are electrically connected to each other via the second through holes 8 passing through the insulating substrate 2, and the adjacent unit cells are connected in series. In the thin-film photovoltaic cell 1, the transparent electrode layer 5 around the second through holes 8 is separated by the separation grooves 11, and the transparent electrode layer 5 and the second back-face electrode layer 6 are electrically insulated from each other. In the related art, mask treatment is performed or an insulating resin is disposed around the second through holes, but in accordance with the present invention, electric insulation between the transparent electrode layer 5 and the second back-face electrode layer 6 in the second through holes 8 can be ensured without performing such a treatment. Furthermore, because of the configuration in which the transparent electrode layer 5 is removed by laser, without performing the mask treatment around the second through holes 8, the region where the transparent electrode layer 5 is not formed can be reduced by comparison with that obtained with the mask treatment, and the effective surface area of the transparent electrode layer 5 can be enlarged. As a result, the output of the thin-film photovoltaic cell 1 can be increased.

Further, in the thin-film photovoltaic cell 1 according to the first embodiment of the present invention, a pulsed laser is used to form the separation grooves 11. Therefore, short circuiting of a power-generating layer such as the photoelectric conversion layer 4 caused by crystallization can be inhibited.
Further, since a short time width (equal to or less than 100 ps) of the pulsed laser pulses is set, thermal influence produced during laser processing can be reduced.

The method for manufacturing the thin-film photovoltaic cell 1 according to the first embodiment of the present invention includes a step of forming the second through holes 8 in the insulating substrate 2; a step of forming the rear-face electrode layer 3a on the one face 2a of the insulating substrate 2 and forming the first back-face electrode layer 3b on the other face 2a of the insulating substrate 2; a step of forming the first through holes 7 in the insulating substrate 2 after the rear-face electrode layer 3a and the first back-face electrode layer 3b have been formed; a step of stacking the photoelectric conversion layer 4 and the transparent electrode layer 5 in the order of description from the one face side 2a of the insulating substrate 2, and stacking the second back-face electrode layer 6 from the other face side 2b of the insulating substrate 2; a step of forming patterning lines 9, 10 alternately in the layers stacked on both faces 2a, 2b of the insulating substrate 2 and dividing the insulating substrate 2 into a plurality of unit cells; and a step of forming the separation grooves 11 in the transparent electrode layer 5 around the second through holes 8 and electrically insulating the transparent electrode layer 5 and the second back-face electrode layer 6 from each other. Therefore, it is not necessary to perform a mask treatment or the like in the vicinity of the second through holes, as in the related art, and the production yield of the thin-film photovoltaic cell 1 can be increased. In addition, because no mask treatment is necessary to perform in the vicinity of the second through holes 8, the layer located on the insulating substrate 2 that is in contact with the mask and the insulating substrate 2 is prevented from damage. As a result, the leak current is prevented from increasing in the thin-film photovoltaic cell 1 and the defect ratio in the production of the thin-film photovoltaic cell 1 can be reduced.

### Second Embodiment

The thin-film photovoltaic cell 1 according to the second embodiment of the present invention will be described below. In the thin-film photovoltaic cell 1 according to the second embodiment, the manufacturing steps preceding the formation of the separation grooves 11 (see FIG. 5(b)) are same as those in the first embodiment. Accordingly, the redundant explanation thereof is herein omitted.

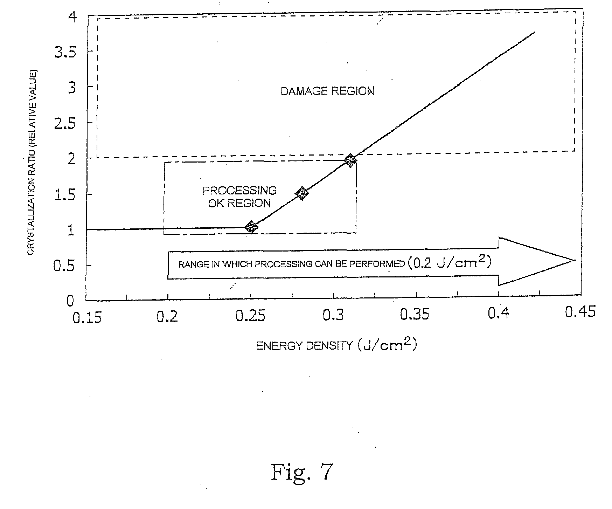

FIG. 7 illustrates the relationship between energy density and crystallization ratio during processing of the transparent electrode layer 5 (see FIG. 5(b)) by laser beam irradiation. The crystallization ratio as referred to herein is calculated by using a peak intensity ratio measured by Raman spectroscopy. Where the peak intensity of crystalline Si is denoted by Ic and the peak intensity of amorphous Si is denoted by Ia, the Ic/Ia ratio is the crystallization ratio. The relative value of crystallization ratio after laser irradiation is determined by taking the crystallization ratio of the power-generating layer prior to laser irradiation as 1.

As shown in FIG. 7, where the energy density increases, thermal damage to the power-generating layer increases and the crystallization advances (that is, the crystallization ratio increases). Where the energy density is too small, the processing of the transparent electrode layer 5 is impossible. Therefore, the energy density in laser processing should be 0.2 J/cm². Where the upper threshold for the crystallization ratio is taken as 2 (relative value), the upper limit value for the energy density will be 0.31 J/cm², as shown in FIG. 7.

In the second embodiment, a YAG-THG laser (wavelength 355 nm) is used as means for processing the transparent electrode layer 5 and forming the separation grooves 11. Further, the energy density of the YAG-THG laser is set within a range of 0.2 to 0.3 J/cm² by using the results shown in FIG. 7.
Further, where the laser energy density is within a range of 0.2 to 0.3 J/cm², a beam with a round Gaussian distribution can be used. It is preferred that a rectangular-shaped beam (top hat) with good energy distribution be used.

Where the laser pulse time width is reduced, thermal influence can be inhibited in the same manner as in the first embodiment. The time width of the pulsed laser pulses may be set equal to or less than 100 ps, preferably equal to or less than 20 ps.

With the method for manufacturing the thin-film photovoltaic cell 1 according to the second embodiment of the present invention, the separation grooves 11 are formed using the YAG-THG laser (wavelength 355 nm) with a beam energy density adjusted to 0.2 to 0.3 J/cm². Therefore, the modification (that is, crystallization or the like) of the surrounding power-generating layer, such as the photoelectric conversion layer, by laser processing can be inhibited.
Further, since a laser in a UV radiation range (wavelength equal to or less than 400 nm) is used for processing, the absorption of light in the transparent electrode layer 5 increases and thermal damage to the power-generating layer can be reduced.

The embodiments of the present invention are described above, but the present invention is not limited to the above-described embodiments, and various changes and modifications can be made without departing from the technical essence of the present invention.

In the above-described embodiments, the separation grooves 11 are formed annularly in the plane view thereof, but other shape may be also used, provided that the transparent electrode layer 5 and the second transparent electrode layer 6 are electrically insulated from each other. For example, the separation grooves 11 may be formed in a rectangular shape, in the plan view thereof, around the second through holes 8.

In the above-described embodiments, the step (S11) of laser processing the transparent electrode layer 5 around the second through holes 8 is the very last step, but the order of step S11 in the manufacturing method can be changed, provided that this step is implemented after step S8.

### EXPLANATION OF REFERENCE NUMERALS

- 1: thin-film photovoltaic cell
- 2: insulating substrate
- 3: metal electrode layer
- 3a: rear-face electrode layer
- 3b: first back-face electrode layer
- 4: photoelectric conversion layer
- 5: transparent electrode layer
- 6: second back-face electrode layer
- 7: first through hole
- 8: second through hole
- 9: first patterning line
- 10: second patterning line
- 11: separation groove

## Claims

1. A thin-film photovoltaic cell in which a rear-face electrode layer, a photoelectric conversion layer, and a transparent electrode layer are stacked in this order on one face of an insulating substrate, a first back-face electrode layer and a second back-face electrode layer are stacked in this order on the other face of the insulating substrate, the insulating substrate is divided into a plurality of unit cells by forming patterning lines alternately in the layers stacked on both faces of the insulating substrate, the transparent electrode layer and the second back-face electrode layer are electrically connected to each other via a first through hole passing through the insulating substrate, the rear-face electrode layer and the first back-face electrode layer are electrically connected to each other via a second through hole passing through the insulating substrate, and the adjacent unit cells are connected in series, wherein
the transparent electrode layer around the second through hole is separated by a groove, and the transparent electrode layer and the second back-face electrode layer are electrically insulated from each other.

2. The thin-film photovoltaic cell according to claim 1, wherein the groove of the transparent electrode layer is formed by irradiation with a pulsed laser.

3. The thin-film photovoltaic cell according to claim 1 or 2, wherein the groove of the transparent electrode layer is formed by irradiation with a laser beam with a wavelength in a UV radiation range.

4. The thin-film photovoltaic cell according to any one of claims 1 to 3, wherein the insulating substrate is formed from a heat-resistant film of a polyimide, a polyamidoimide, or polyethylene naphthalate.

5. A thin-film photovoltaic cell in which a rear-face electrode layer, a photoelectric conversion layer, and a transparent electrode layer are stacked in this order on one face of an insulating substrate, a first back-face electrode layer and a second back-face electrode layer are stacked in this order on the other face of the insulating substrate, the insulating substrate is divided into a plurality of unit cells by forming patterning lines alternately in the layers stacked on both faces of the insulating substrate, the transparent electrode layer and the second back-face electrode layer are electrically connected to each other via a first through hole passing through the insulating substrate, the rear-face electrode layer and the first back-face electrode layer are electrically connected to each other via a second through hole passing through the insulating substrate, and the adjacent unit cells are connected in series, wherein
the transparent electrode layer around the second through hole is separated by a groove, the transparent electrode layer and the second back-face electrode layer are electrically insulated from each other, and the groove is formed using a YAG-THG laser (wavelength 355 nm) with a beam energy density adjusted to 0.2-0.3 J/cm².

6. The thin-film photovoltaic cell according to claim 5, wherein the groove of the transparent electrode layer is formed using a laser with a round or rectangular beam shape and a Gaussian or top-hat beam profile.

7. The thin-film photovoltaic cell according to claim 5 or 6, wherein the groove of the transparent electrode layer is formed using a laser with a pulse width equal to or less than 20 ps.

8. The thin-film photovoltaic cell according to any one of claims 5 to 7, wherein the insulating substrate is formed from a heat-resistant film of a polyimide, a polyamidoimide, or polyethylene naphthalate.

9. A method for manufacturing a thin-film photovoltaic cell, comprising:
a step of forming a second through hole in an insulating substrate;
a step of forming a rear-face electrode layer on one face of the insulating substrate and forming a first back-face electrode layer on the other face of the insulating substrate;
a step of forming a first through hole in the insulating substrate after the rear-face electrode layer and the first back-face electrode layer have been formed;
a step of stacking a photoelectric conversion layer and a transparent electrode layer in this order from the one face side of the insulating substrate, and stacking a second back-face electrode layer from the other face side of the insulating substrate;
a step of forming patterning lines alternately in the layers stacked on both faces of the insulating substrate and dividing the insulating substrate into a plurality of unit cells; and
a step of forming a groove in the transparent electrode layer around the second through hole and electrically insulating the transparent electrode layer and the second back-face electrode layer from each other.

10. The method for manufacturing a thin-film photovoltaic cell according to claim 9, wherein the step of forming the groove in the transparent electrode layer around the second through hole is performed by irradiation with a pulsed laser.

11. The method for manufacturing a thin-film photovoltaic cell according to claim 9 or 10, wherein the step of forming the groove in the transparent electrode layer around the second through hole is performed by irradiation with a laser beam with a wavelength in a UV radiation range.

12. The method for manufacturing a thin-film photovoltaic cell according to any one of claims 9 to 11, wherein the step of forming the groove in the transparent electrode layer around the second through holes is performed by irradiation with a YAG-THG laser beam (wavelength 355 nm) with a beam energy density adjusted to 0.2-0.3 J/cm².

13. The method for manufacturing a thin-film photovoltaic cell according to any one of claims 9 to 12, wherein the step of forming the groove in the transparent electrode layer around the second through hole is performed by irradiation with a laser with a round or rectangular beam shape and a Gaussian or top-hat beam profile.

14. The method for manufacturing a thin-film photovoltaic cell according to any one of claims 9 to 13, wherein the step of forming the groove in the transparent electrode layer around the second through hole is performed by irradiation with a laser with a pulse width equal to or less than 20 ps.
